# EUROPEAN PATENT SPECIFICATION

(11) **EP 2 952 435 B1**
(45) Date of publication and mention of the grant of the patent: **04.01.2017**
(21) Application number: 15170574.6
(22) Date of filing: 03.06.2015
(51) Int. Cl.: B64F 5/00, G01B 11/27

(54) **METHOD AND APPARATUS FOR ALIGNING SEGMENTS**
VERFAHREN UND VORRICHTUNG ZUR AUSRICHTUNG VON SEGMENTEN
PROCéDé ET APPAREIL POUR L'ALIGNEMENT DE SEGMENTS

(30) Priority: 04.06.2014 DE 102014107855
(43) Date of publication of application: 09.12.2015
(73) Proprietor: Airbus Operations GmbH, 21129 Hamburg (DE)
(72) Inventor: Bense, Rolf, 21129 Hamburg (DE); Weiß, Oliver, 21129 Hamburg (DE)
(74) Representative: Kopf Westenberger Wachenhausen Patentanwälte PartG mbB

(56) References cited:
- WO-A1-2010/130420
- US-A- 5 929 984
- US-A1- 2010 049 354
- US-B1- 6 230 382

## Description

### Field of the invention

The present invention relates to the technical field of aviation and aerospace. The present invention relates in particular to a method for aligning segments with one another, to an apparatus for aligning segments and to a computer-readable storage medium with a program code for a method for aligning segments with one another.

### Background of the invention

To align segments such as large fuselage parts with one another before the joining process, these fuselage parts are positioned on a support apparatus or a positioning device to align them with one another so that they fit together as exactly as possible. The alignment process itself is then performed by visual judgment, i.e. the joining process is carried out in the final assembly line by the workers and by quality control, wherein attempts being made to align the segments with one another by minimising gaps between the segments. The result of the alignment process is greatly influenced by the accuracy with which the gaps can be measured.

Document DE 10 2006 019 917 A1 describes segments, measurement points of which are recorded, the segments being moved using the measurement points to the exact desired position according to the later arrangement thereof inside an aircraft structure.

Document DD 292 520 A5 relates to a laser system for testing and positioning large components, a horizontal rotary laser allowing the generation of planes which are oriented parallel to a construction site at a variable height above said site.

US 6 230 382 B1 describes a method for assembling an aircraft. The method comprises the determination of a three-dimensional representation of a first aircraft structure and a second aircraft structure using an optical positioning device. A predicted mate of the first and second aircraft structure is generated from the three-dimensional representation. The method also includes adjusting the predicted mate.

US 5 929 984 A describes a laser system for precisely locating points in a space relative to a reference plane. The system includes a laser generator capable of sweeping a plurality mutually perpendicular laser planes and/or one laser plane and one laser beam perpendicular thereto.

WO 2010/130420 A1 describes a measuring device for determining the position and orientation of a support means relative to a reference axis.

Leica Geosystems AG, CH-9435 Heerbrugg (Switzerland), http://www.leica-geosystems.de/downloads123/zz/lasers/LineandDotLasers/manuals/Leica%20Lino%20MA N%201009%20757665b_en.pdf, "User Manual Leica Lino L360, L2P5, L2+, L2, P5, P3", Original Text (757665g EN), 2012 describes an apparatus for projecting lines onto objects using a laser.

### Summary of the invention

There may be a need to provide a more efficient alignment of segments.

Accordingly, a method for aligning segments with one another and an apparatus for aligning segments and also a computer-readable storage medium with a program code for a method for aligning segments with one another are described.

The invention is defined by the features of the independent claims. Exemplary embodiments may be provided in the dependent claims and in the following description.

According to one aspect of the invention, a method for aligning segments with one another may be described, wherein a first segment comprises a first group of reference points and a second group of reference points and wherein a second segment comprises a third group of reference points and a fourth group of reference points. These reference points can be markers, for example, which are applied to the segments manually or by a specific process. The markers or reference points can also be provided as adhesive labels on the segments. Furthermore, the reference points of the first and third groups are substantially located on a first common line running parallel to a longitudinal axis of the first and second segments. The reference points of the second and fourth groups are substantially located on a second common line also running parallel to a longitudinal axis of the first and second segments. The term "common line" may mean that the line is a continuous line for the segments in an installed state, for example based on an aircraft coordinate system. The common line may run on the surface of the segments and may lie in a predeterminable plane. The common line can follow or trace the surface structure of the segments and does not necessarily have to be a straight line. The line can be respectively a linear structure resulting from an intersection of the surface of the segments with a plane.

The reference points may be based on a component coordinate system or on an aircraft coordinate system because they are applied directly to the associated component and are to designate a fixed point in the component coordinate system. A group of reference points can be at least two reference points or a plurality of reference points. For example, the markers, marks or reference points on aircraft fuselage segments to be joined together are applied to the respective fuselage segment as FD (fuselage datum) marks or as NSA (norme sud aviation) points, these marks or points being based on the aircraft coordinate system or AC coordinate system (Aircraft Coordinate System). The FD marks specify the x-y plane when z = 0, based on the aircraft coordinate system, i.e. a reference plane. The z-axis of the aircraft coordinate system represents the vertical axis of the aircraft fuselage parts and the y-axis is perpendicular to the z-axis and x-axis according to a right hand system and is oriented in the direction of the wingspan. The x-axis is oriented in the direction of the aircraft longitudinal axis. It is possible for further groups of reference points or markers to be provided which substantially lie on a common line. In one example, the method can also comprise the application of the reference points or markers to the corresponding segments. In one example, the method can also provide forming of a corresponding group of reference points from a plurality of available reference points. Thus, the reference points can be markers which are selected according to predeterminable criteria, for example because they lie on a plane or line, with reference to an aircraft coordinate system.

In the following, it may be assumed that segments are provided having corresponding groups of reference points, for example by arranging a first segment on a first positioning device and by arranging a second segment on a second positioning device. In one example, the two segments may be roughly aligned with one another so that they are aligned with one another along a longitudinal axis and/or the reference points are visible.

The method provides the projection of a first projection line onto the first segment and onto the second segment by a first projection device. Furthermore, a second projection line is projected onto the first segment and onto the second segment by a second projection device. In one example, for projecting the lines a laser beam may be used which is moved on a plane between a predeterminable angular range or angular region so that when the beam strikes a surface, a line is produced. The angular range may be respectively selected such that the line covers, runs across or spans both segments.

The projection devices are referred to, for example, a construction site coordinate system or construction coordinate system. The construction site coordinate system may be a coordinate system, for example, which is used for the movement of the positioning devices and may be referred to, for example, the floor of the production hall in which the segments are to be joined together. The coordinate system of the construction site, i.e. the construction site coordinate system, is established by defined points inside the apparatus, i.e. inside the positioning devices. Within this coordinate system, the projection devices have a defined position which is validated by, for example, annual periodic checks and is corrected if necessary, because the building as well as the apparatus with the positioning devices are subject to settling processes, vibrations etc. Due to the projected lines, the spatial arrangement of specific components as well as the coordinates thereof can be determined with reference to the construction site coordinate system, for example with reference to a construction site or with reference to an assembly hall.

The first projection line is related to the first common line and the second projection line is related to the second common line. Due to this relation or correlation of the projection lines with the common lines, a relationship of the aircraft coordinate system with the construction site coordinate system may be produced. This relationship can be produced, for example by a mathematical conversion of the spatial arrangement of the projection lines and/or of the first common line and of the second common line. It may be also possible to perform a coordinate transformation of the aircraft coordinate system and of the construction site coordinate system. Therefore, it may be possible that a coordinate transformation produces a relation between the first projection line and the first common line and also between the second projection line and the second common line. However, the alignment may become substantially independent of a coordinate system due to the projection of the lines.

In addition, further projection lines can also be projected onto the first segment and/or onto the second segment by further projection device. For example, a third projection line can be projected onto the first segment and onto the second segment. In one example, the further projection line may be projected such that the further projection line lies on and/or in a plane with the first or second projection line. For example, the further projection line may lie on a side of the segment opposite the first or second projection line.

The projection lines can be projected onto the segments from any direction. The projection lines can be aligned, for example substantially parallel to a segment axis and can run on the surface of the segments onto which they have been projected. For example, the first projection line runs substantially along the first group and the third group of reference points or along the first common line. Furthermore, the second projection line runs substantially along the second group and the fourth group of reference points or along the second common line.

The method also provides measuring of the distances between each of the reference points of the first group to the first projection line and between each of the reference points of the third group to the first projection line by letting fall a perpendicular onto the first projection line. Furthermore, the distances are measured between each of the reference points of the second group to the second projection line and between each of the reference points of the fourth group to the second projection line by letting fall a perpendicular onto the second projection line. In this respect, the perpendicular is substantially the shortest distance between the projected line and the associated reference point. The distance is determined in a coordinate direction depending on the feature, for example NSA or FD. For example, to determine the distances of the NSA points from the projection line, the distance measured along the y-coordinate is determined.

It may be pointed out that the distances are measured between each individual reference point of a specific group to the respectively associated projection line so that the coordinates of the reference points which were originally available in a component coordinate system or aircraft coordinate system are now also available, by the distance determination, with reference to a construction coordinate system or construction site coordinate system. This is due to the fact that the projection devices and thus also the lines projected onto the segments by these projection devices are referred to the construction site coordinate system. If the distance of the reference points to these projected lines is determined, the spatial arrangement of the reference points applied to the segments with reference to the construction site coordinate system can be determined. The distances can be measured by a measuring device, in particular by an optical measuring device, such as a camera. However, other measuring devices or recording systems for measuring the distances are also possible. A plurality of measuring devices can be installed on the construction site so that for each reference point a measuring device or an individual measuring device is provided which is respectively associated with this reference point and measures the distance between the projection line and the reference point. The measuring devices are installed on the construction site, as a result of which the measuring devices are referred to the construction site coordinate system. In one example, the absolute position of the recording system or of the measuring device is selected such that the projection line and the associated reference point can be recorded or detected. A greater degree of accuracy has to be used when positioning the projection device compared to when the recording system is positioned.

The method further provides the determination of a first best-fit plane of the first segment and a second best-fit plane of the first segment. Furthermore, a first best-fit plane of the second segment and a second best-fit plane of the second segment are determined. A best-fit plane may be a theoretical plane or an auxiliary plane which represents as effectively as possible the plane based on the construction site coordinate system or the construction coordinate system, on which the measured values of the reference points are located. The best-fit planes should reproduce the position of the planes in the construction site coordinate system, on which planes the reference points of a group are located. However, due to distortion and torsion, groups of reference points which lie on a line and/or plane, in an aircraft coordinate system used during construction, may no longer lie on a line and/or plane during assembly of the segments. Therefore, a theoretical plane may be used which represents the line and/or plane as effectively as possible on which the measured reference points of a group are located. This theoretical plane may be the best-fit plane.

To construct the best-fit plane, the projection line respectively associated with a group of reference points is used, it being assumed that said projection line lies on a common plane for both segments in the construction site coordinate system. The formation of the best-fit planes may comprise the detection of the groups of reference points in the construction site coordinate system. The best-fit planes can be determined by any mathematical method. For example, in determining the best-fit planes, a regression is made to the associated reference points, in particular to the measured values of the reference points or to the measured coordinates of the reference points. The determination and/or calculation of the best-fit-planes may for example be carried out by a minimisation of the error squares of a certain number of measurement points or reference points. How well a best-fit plane reproduces the plane on which the measured values of the reference points are located may depend on the mathematical method used. Due to the best-fit plane, positioning inaccuracies with respect to the reference points can be evened out, thereby producing a theoretical or virtual reference plane within the aircraft fuselage section. In this respect, "even out" means that a balance is achieved between negative and positive deviations in the distances of the reference points or markers to the best-fit planes. This evening-out may be necessary because the FD marks do not always have the same z-coordinates due to inaccuracies, so that the FD marks do not lie in one plane.

As an alternative or in addition to the best-fit planes, the method can further provide the determination of a first best-fit line of the first segment and a second best-fit line of the first segment, the characteristics of the best-fit planes applying analogously to the best-fit lines and vice versa. Furthermore, a first best-fit line of the second segment and a second best-fit line of the second segment can be determined. A best-fit line may be a line which represents as effectively as possible the line on which the measured values of the reference points are located, referred to the construction site coordinate system,. In one example, a best-fit plane can be determined from a best-fit line and vice versa. The best-fit lines are to reproduce the position of those lines in the construction site coordinate system on which the reference points of a group are located. However, due to distortion and torsion, groups of reference points which lie on a line in an aircraft coordinate system used during construction, may no longer lie on a line during assembly of the segments. Therefore, it may be possible to work with a theoretical line which represents as effectively as possible the line on which the measured reference points of a group are located. This theoretical line may be the best-fit line. To construct the best-fit line, the projection line respectively associated with a group of reference points is used, it being assumed that said projection line lies on a common plane for both segments in the construction site coordinate system. The formation of the best-fit lines may comprise the detection of the groups of reference points in the construction site coordinate system. The best-fit lines can be determined by any mathematical method. For example, in determining the best-fit lines, a regression is made to the associated reference points, in particular to the measured values of the reference points or to the measured coordinates of the reference points. In this case, the best-fit line may be a regression line or a regression curve for the measured points. How well a best-fit line reproduces the line on which the measured values of the reference points are located may depend on the mathematical method used.

A best-fit plane may be a virtual spatial reference plane which describes the alignment of a segment. The first best-fit plane of the first segment may be determined based on the established coordinates of the reference points of the first group. To determine the best-fit plane, an evaluation device and/or a computing device may be provided which evaluates the coordinates of the reference points and uses them as a starting point to determine the best-fit planes. Analogously, the first best-fit plane of the second segment may be determined based on the determined coordinates of the reference points of the third group. The second best-fit plane of the first segment may be determined based on the determined coordinates of the reference points of the second group. Analogously, the second best-fit plane of the second segment may be determined based on the determined coordinates of the reference points of the fourth group. The second best-fit planes can be rotated about the longitudinal axis of the segments by a specific angle with respect to the first best-fit planes. In particular, second best-fit planes can be determined which are perpendicular to the first best-fit planes. Further best-fit planes can be determined based on further groups of reference points which are applied to the segments. For example, a further best-fit plane of the first segment can be determined which is inclined at a specific angle to the first and second best-fit planes of the first segment. Analogously, a further best-fit plane of the second segment can also be determined which is inclined at a specific angle to the first and second best-fit planes of the second segment. A best-fit plane can simultaneously also relate to opposite groups, for example to groups on the right-hand side and left-hand side of a segment. These further best-fit planes are, for example, virtual reference planes which are rotated about the segment longitudinal axes with respect to the first and second best-fit planes. Thus, the best-fit planes represent the current alignment of the respective segments. Since the best-fit planes have been calculated with respect to the construction site coordinate system, for example the alignment of the segments with respect to the construction site coordinate system is also known.

A best-fit line may be a virtual reference line in a space which describes or characterizes the alignment of a segment. The first best-fit line of the first segment may be determined based on the determined or established coordinates of the reference points of the first group. To determine the best-fit line, an evaluation device and/or a computing device may be provided which evaluates the coordinates of the reference points and uses them as a starting point to determine the best-fit lines. Analogously, the first best-fit line of the second segment may be determined based on the established coordinates of the reference points of the third group. The second best-fit line of the first segment may be determined based on the determined coordinates of the reference points of the second group. Analogously, the second best-fit line of the second segment may be determined based on the determined coordinates of the reference points of the fourth group. Further best-fit lines can be determined based on further groups of reference points which are applied to the segments. For example, a third best-fit line of the first segment can be determined based on a fifth group of reference points. A third best-fit line of the second segment can be determined based on a sixth group of reference points. The best-fit lines represent the current alignment of the respective segments. Since the best-fit lines have been calculated with respect to the construction site coordinate system, for example the alignment of the segments with respect to the construction site coordinate system is also known.

After being established, a best-fit plane and/or a best-fit line may be linked with the associated segment and used for alignment, deformations of the segments being substantially compensated.

The method further provides that the first best-fit plane of the first segment and the first best-fit plane of the second segment are aligned on the first projection line. Furthermore, the second best-fit plane of the first segment and the second best-fit plane of the second segment are aligned on the second projection line. During alignment, the best-fit planes are changed in position and/or orientation such that they are at the shortest possible distance from the projection lines. Since the segments move with the best-fit planes due to the alignment of the best-fit planes on the segment-spanning projection lines, the fuselage parts can be levelled as a result of alignment.

Accordingly, the method can provide that the first best-fit line of the first segment and the first best-fit line of the second segment can be aligned on the first projection line. Furthermore, the second best-fit line of the first segment and the second best-fit line of the second segment can be aligned on the second projection line. During alignment, the best-fit lines are changed in position and/or orientation such that they are at the shortest possible distance from the projection lines. The fuselage parts can be levelled as a result of the alignment of the best-fit lines on the segment-spanning projection lines.

Levelling or alignment is carried out, for example by positioning devices on which the segments for the alignment process are mounted, as a result of which mounting alignment can be substantially automated. The positioning device can be lifting or supporting apparatuses onto which the segments are jacked. A positioning device can consist of a plurality of supporting towers which can be moved and/or adjusted independently of one another. Adjustment can be performed such that the respective segments can be moved in all directions and can be rotated about all axes.

An aircraft coordinate system may be a coordinate system which is used during the construction of an aircraft and on which the components of an aircraft, such as a seat rail, a floor, a monument, a wing or a tail unit are based in a segment-spanning manner during the planning of an aircraft. For the assembly of an aircraft, individual segments may be manufactured which are assembled in an assembly hall. During assembly of the segments, only a construction site coordinate system is available for orientation. It may be considered as an idea of the invention to mutually align components with one another which are based on the aircraft coordinate system. During alignment, actuators, positioning devices or towers are used, for example, which are based on a construction site coordinate system. Thus, during assembly of fuselage parts of an aircraft, it may be important that the floor, which is a plane inside the cylindrical fuselage, is consistently dimensionally accurate when the fuselage parts arc assembled. To observe dimensional accuracy, markers or reference points are used which are referred to an aircraft coordinate system. Due to the use of laser beams which emanate from laser projectors and are linked with the construction site coordinate system, a relationship is created between the aircraft coordinate system and the construction site coordinate system. In order to be able to compensate for distortions as effectively as possible when the fuselage parts are joined together, best-fit lines and/or best-fit planes are formed from reference marks which are positioned as far apart as possible and are to represent the position of the planes, formed by the reference points, in the construction site coordinates. The reference points are generally present in an aircraft, for example in order to be able to carry out measurements of the aircraft geometry following hard landings to check that said geometry has not suffered any deformations as a result of mechanical stress. To select the best-fit lines and/or best-fit planes, markers are used which lie on a line over the entire length of the aircraft and/or in a plane. Since a single laser is used to project the lines onto both fuselage parts, a relationship is created between the individual segments or fuselage parts, using which relationship the best-fit lines and/or best-fit planes are aligned. The best-fit lines and/or best-fit planes then represent the current alignment of the respective fuselage parts. During alignment of the fuselage parts, the best-fit lines and/or best-fit planes of the respective segments are brought into congruence so that the fuselage parts can subsequently be fitted together. Since the segments are related or connected to the best-fit lines and/or best-fit planes, due to the alignment of the best-fit lines and/or best-fit planes of the segments with one another, the segments themselves are also aligned with one another.

In other words, the described method and/or the described device may provide that on the individual segments, groups of reference points which lie on a common segment-spanning plane in an aircraft coordinate system, are re-found in a construction site coordinate system, are approximated by best-fit lines and/or best-fit planes and that the segments are aligned in that the best-fit lines and/or best-fit planes are brought into a defined position relative to one another.

The method can be widely used wherever it is a matter of allocating construction elements within two segments which are referred to, related to or based on a common coordinate system. In particular, the method may be used for assembling rotationally symmetrical segments with segment-spanning components, such as a segment-spanning floor, for which components it is important to align the rotationally symmetrical segments and the components which may be located inside the segments and which cannot therefore be easily aligned by optical methods.

According to another aspect of the invention, the method for aligning segments with one another may comprise the projection of a further projection line onto the first segment and onto the second segment by a further projection device. This may mean that the further projection line is generated on the segments, for example on another side of the segment. The provision of a further projection line may increase the alignment accuracy of a segment. For example, the further projection line may lie on the same plane as the first projection line and may be provided for a corresponding group of points.

According to another aspect of the present invention, the projection lines are projected onto the surfaces of the segments, the projection lines being referred to a construction site coordinate system.

The projection lines are generated, for example by laser beams which are projected onto the surface of the segments. A laser beam may generate a very accurate projection line which may lie in a plane which may be described or defined by the deflection direction and by the propagation direction emanating from the laser source. To generate the projection lines, it is possible to provide on the construction site a single, at least two or a plurality of projection devices, which can project projection lines onto the segments from any direction. For example, the projection devices may be referred to or based on a construction site coordinate system in order to be able to determine the distances of specific reference points or markers applied to the segments to the projection lines on the construction site coordinate system. Due to the projected lines and to the distance measurement, it is possible to determine the spatial arrangement of the reference points which was originally only known on the component coordinate system or segment coordinate system, in respect of a construction site coordinate system which is stationary in an example. The construction site coordinate system may be, for example, a fixed coordinate system in an assembly hall in which the segments are aligned with one another and/or are assembled.

According to another aspect of the invention, the reference points are referred to an aircraft coordinate system.

The reference points are applied to the segments which are to be aligned with one another. For example, if aircraft fuselage parts or aircraft fuselage segments are provided with markers, then they are usually referred to an aircraft coordinate system which may be used during the planning of the aircraft. In this respect, specific reference points, named as FD marks, are arranged on the aircraft fuselage segments substantially parallel to the aircraft longitudinal axis. In an example, the longitudinal axis may denote the x-axis of the aircraft coordinate system. This aircraft coordinate system may have its origin in a flight direction in front of the cockpit of the aircraft. The y-axis may denote the direction of the wings and the z-axis may denote the direction of the rudder unit. The position of the markers relative to one another can change, for example when there is distortion in the segments, for example if mechanical or thermal stresses act on the segment during the assembly procedure. The FD points and the NSA points are reference points which are arranged on the aircraft fuselage segments substantially parallel to the aircraft longitudinal axis. For example, the reference points are applied to the surface of the segments, in particular to the outer skin of the aircraft fuselage segments, the segments having a shell-shaped structure. It may be pointed out that it is possible to allocate to each reference point a measuring device, which can determine the distance between the reference point and a projection line by letting fall a perpendicular onto the projection line.

According to a further aspect of the invention, the distances are measured by an optical method.

In one example, cameras are installed on the construction site, which are allocated to a respective reference point, the distance of which to a projection line is to be determined. The cameras send the filmed images to an evaluation device, for example to image capturing software. The evaluation device may be configured to determine a distance between a reference point and the respective projection line. However, apart from a camera, other recording systems and/or measuring methods are also possible which can determine the distance.

According to a further aspect of the invention, the distance measurement and/or the alignment procedure are performed with reference to the construction site coordinate system.

Due to the reference to the construction site coordinate system, all the distances may be known with reference to the same coordinate system. Consequently, the coordinates or the spatial arrangement of the reference points can also be determined with reference to the construction site coordinate system. Accordingly, the segments can be aligned with one another with a high level of accuracy after determining the best-fit lines and/or best-fit planes, the position of which in relation to the construction site coordinate system is also known. This may mean that the alignment with reference to the construction site coordinate system can be used, so that the segments to be aligned are referred to the same coordinate system. Since work is thus not carried out with absolute spatial points, deviations of the reference points from their desired positions on the segments can be disregarded.

According to a further aspect of the invention, the method further provides that the segments are aligned such that the first best-fit plane of the first segment and the first best-fit plane of the second segment are congruent or that the vertical or perpendicular distance of the first best-fit plane of the first segment to the first best-fit plane of the second segment is adjusted. In this respect, the adjustment of the vertical distance may mean that a distance in a z-axis of the construction site coordinate system, i.e. vertical to or perpendicular to a hall floor, is minimised, wherein the best-fit planes being aligned parallel to one another. Congruence of two planes may mean that the planes are substantially lying into one another or they are completely lying into one another. Consequently, the best-fit-planes of two segments may be congruent or at least approximately congruent. Substantially lying into one another may mean that a complete congruence can only be achieved in theory and that slight deviations from a complete congruence may occur due to measuring inaccuracies.

By adjusting a vertical distance of the first best-fit plane of the first segment and the first best-fit plane of the second segment, two rotational degrees of freedom and one translational degree of freedom with respect to a relative movement of the segments to one another can be restricted.

Furthermore, a second best-fit plane of the first segment and a second first best-fit plane of the second segment can be determined which are respectively inclined at a specific angle, for example at a right angle, with respect to the first best-fit planes, about the longitudinal axis of the first and second segments. The segments can be aligned such that the second best-fit plane of the first segment and the second best-fit plane of the second segment are congruent or that the vertical distance of the second best-fit plane of the first segment to the second best-fit plane of the second segment is adjusted. It is thereby possible to restrict a further translational degree of freedom and a further rotational degree of freedom with respect to a relative movement of the segments to one another, as a result of which only a displacement of the segments in the longitudinal direction thereof is still possible. Thus, due to the adjustment of the vertical or perpendicular distance of the first best-fit planes and of the second best-fit planes, it is possible to achieve an exact alignment of the segments for a subsequent joining process. Congruence of the first best-fit planes is achieved when the vertical distance between them is equal to zero. Analogously, congruence between the second best-fit planes is achieved when the vertical distance between them is zero.

According to a further aspect of the invention, the method can provide that best-fit lines are used as an alternative or in addition to best-fit planes. Thus, the method may provide that the segments are aligned such that the first best-fit line of the first segment and the first best-fit line of the second segment are congruent or that the vertical distance of the first best-fit line of the first segment to the first best-fit line of the second segment is adjusted. In this respect, the adjustment of the vertical distance may mean that a distance in a z-axis of the construction site coordinate system, i.e. vertical to a hall floor, is minimised, the best-fit lines being aligned parallel to one another. Furthermore, the segments can be aligned such that the second best-fit line of the first segment and the second best-fit line of the second segment are congruent or that the vertical distance of the second best-fit line of the first segment to the second best-fit line of the second segment is adjusted. The degrees of freedom can thereby be restricted such that only a displacement of the segments in the longitudinal direction thereof is still possible. Thus, due to the adjustment of the vertical distance of the first best-fit lines and of the second best-fit lines, it is also possible to achieve an exact alignment of the segments for a subsequent joining process. Congruence of the first best-fit lines is achieved when the vertical distance between them is equal to zero. Analogously, congruence between the second best-fit lines is achieved when the vertical distance between them is zero. Congruence of two best-fit-lines may mean that the lines are substantially lying into one another or they are completely lying into one another. Consequently, the best-fit-lines of two segments may be congruent or approximately congruent. Substantially lying into one another may imply that a complete congruence can only be achieved in theory and that slight deviations from a complete congruence may occur due to measuring inaccuracies.

According to a further aspect of the invention, the method further provides that the first segment can be fitted together, assembled or joined together with the second segment, the alignment of the segments with one another being preserved when they are joined together. The alignment of the segments with one another may be predetermined by the congruence of the first best-fit line and/or the first best-fit plane of the first segment with the first best-fit line and/or the first best-fit plane of the second segment and by the congruence of the second best-fit line and/or the second best-fit plane of the first segment with the second best-fit line and/or best-fit plane of the second segment. In this respect, the second best-fit planes of each segment can be aligned such that they are respectively inclined about the longitudinal axis of the segments relative to the first best-fit planes. For example, this inclination is 90 °.

A best-fit line and a best-fit plane may be used in a similar manner so that what is stated for a best-fit plane may also apply accordingly to a best-fit line, and vice versa.

According to a further aspect of the invention, the method for aligning segments with one another comprises the alignment of the first best-fit plane of the first segment and of the first best-fit plane of the second segment such that the first best-fit plane of the first segment and the first best-fit plane of the second segment are congruent and/or comprises the alignment of the second best-fit plane of the first segment and of the second best-fit plane of the second segment such that the second best-fit plane of the first segment and the second best-fit plane of the second segment are congruent.

During alignment, a specific vertical or perpendicular distance between the first best-fit plane of the first segment and the first best-fit plane of the second segment or between the second best-fit plane of the first segment and the second best-fit plane of the second segment can also be adjusted. The best-fit planes may be virtual or theoretical reference planes which represent the alignment of the segments. When these virtual reference planes have been determined, it is assumed that they are fixedly anchored with the respective segments so that when the segments are moved, the reference planes move to the same extent and vice versa.

According to a further aspect of the invention, the method for aligning segments with one another comprises the alignment of the first best-fit line of the first segment and of the first best-fit line of the second segment such that the first best-fit line of the first segment and the first best-fit line of the second segment are congruent and/or comprises the alignment of the second best-fit line of the first segment and of the second best-fit line of the second segment such that the second best-fit line of the first segment and the second best-fit line of the second segment are congruent.

During alignment, a specific vertical distance between the first best-fit line of the first segment and the first best-fit line of the second segment or between the second best-fit line of the first segment and the second best-fit line of the second segment can also be adjusted. The best-fit lines may be virtual or theoretical reference lines which represent the alignment of the segments. When these virtual reference lines have been determined, it is assumed that they are fixedly anchored with the respective segments so that when the segments are moved, the reference lines move to the same extent and vice versa.

According to a further aspect of the invention, the method for aligning segments with one another comprises the alignment of the first best-fit plane of the first segment and of the first best-fit plane of the second segment such that the first best-fit plane of the first segment and the first best-fit plane of the second segment have a minimum distance to the first projection line and/or comprises the alignment of the second best-fit plane of the first segment and of the second best-fit plane of the second segment such that the second best-fit plane of the first segment and the second best-fit plane of the second segment have a minimum distance to the second projection line. Also during this alignment procedure, cameras for example record the distance between the projection lines and the best-fit planes. The sections can be levelled by the alignment of the theoretical best-fit planes with the projected laser beams and/or with the projection lines. In this respect, the respective reference points are aligned with the laser beam, the best-fit planes having a defined position with respect to the reference points and therefore it is possible to infer the position of the reference point in relation to the projection line for a levelling procedure. For example, if the position of a reference point is known, it is possible to infer the position of the best-fit plane. The same applies analogously to a best-fit line.

According to a further aspect of the invention, the method for aligning segments with one another comprises the alignment of the first best-fit line of the first segment and of the first best-fit line of the second segment such that the first best-fit line of the first segment and the first best-fit line of the second segment have a minimum distance to the first projection line and/or comprises the alignment of the second best-fit line of the first segment and of the second best-fit line of the second segment such that the second best-fit line of the first segment and the second best-fit line of the second segment have a minimum distance to the second projection line. Also during this alignment procedure, cameras for example record the distance between the projection lines and the best-fit lines.

According to a further aspect of the invention, the two segments or fuselage parts have a base plate. In particular, the segments can be aircraft fuselage parts with a base plate. After the segments have been aligned with one another, the base plates of the two segments can be joined together. In this respect, after the segments have been aligned with one another and in particular after they have been assembled, the base plates which are rigidly connected to the respective segments are aligned in line so that linear elements can be fastened to the base plates across both base plates. These are, for example, rails for a passenger seat configuration. The plane on which the base plate lies, may lie parallel to one of the planes and/or lines which may be formed from the reference points.

According to a further aspect of the invention, a computer-readable storage medium with a program code is described which, when executed on a processor, implements the method for aligning segments according to any of the previous claims. A processor of this type is installed in an evaluation device, for example. The processor can be connected to the projection devices, to the measuring device, to the evaluation devices and/or to the positioning devices and can control these devices. Furthermore, reference points or markers can also be set according to predeterminable criteria. The method may be configured accordingly to implement the selection of the reference points.

A computer-readable storage medium may be a floppy disk, a hard disk, a USB (universal serial bus) storage medium, a RAM (random-access memory), a ROM (read-only memory) or an EEPROM (electrically erasable programmable read-only memory). It is also possible to consider as a computer-readable storage medium a communications network, such as the Internet which may allow a program code to be played or downloaded.

According to a further aspect of the invention, an apparatus for aligning segments with one another is described. This apparatus comprises a first projection device, a second projection device, a measuring device, an evaluation device and a positioning device.

For example, the apparatus is configured to align a first segment with a second segment. The first segment has a first and second group of reference points. The second segment has a third and fourth group of reference points. The reference points of the first and third groups substantially lie on a first common line running parallel to a longitudinal axis of the first and second segments. The reference points of the second and fourth groups substantially lie on a second common line running parallel to a longitudinal axis of the first and second segments.

The first projection device is configured to project a first projection line onto the first and second segments, the second projection device being configured to project a second projection line onto the first and second segments. The projection means are, for example, laser projectors or other light sources. The first projection line is connected or related to the first common line and the second projection line is connected or related to the second common line.

The measuring device is configured to measure the distances between each of the reference points of the first group to the first projection line and between each of the reference points of the third group to the first projection line by letting fall a perpendicular onto the first projection line. The measuring device is further configured to measure the distances between each of the reference points of the second group to the second projection line and between each of the reference points of the fourth group to the second projection line by letting fall a perpendicular onto the second projection line. A plurality of measuring devices can be provided for the distance measurement. Furthermore, the evaluation device is configured to determine a first best-fit line and/or a first best-fit plane of the first segment and a second best-fit line and/or a second best-fit plane of the first segment, said evaluation device being further configured to determine a first best-fit line and/or a first best-fit plane of the second segment and a second best-fit line and/or a second best-fit plane of the second segment.

The evaluation unit has, for example, a computing unit or a processor which is configured to perform a mathematical regression method or another approximation method to determine the best-fit lines and/or the best-fit planes from the reference points.

The positioning device is configured to align the first best-fit plane of the first segment and the first best-fit plane of the second segment on the first projection line. The positioning device is further configured to align the second best-fit plane of the first segment and the second best-fit plane of the second segment on the second projection line.

Accordingly, the positioning device is configured to align the first best-fit line of the first segment and the first best-fit line of the second segment on the first projection line. The positioning device is further configured to align the second best-fit line of the first segment and the second best-fit line of the second segment on the second projection line.

According to another aspect of the invention, a production hall for aircraft segments is provided which comprises the apparatus for aligning segments.

### Brief description of the drawings

In the following, embodiments will be described with reference to the following drawings.
- Fig. 1: is a side view of an aircraft with an arrangement of reference points according to an exemplary embodiment of the invention.
- Fig. 2: is a plan view of an aircraft with an arrangement of FD marks according to an exemplary embodiment of the invention.
- Fig. 3: is a detail view of FD marks and NSA points according to an exemplary embodiment of the invention.
- Fig. 4: is a side view and a bottom view of the laser projection in the construction site onto two fuselage parts of an aircraft.
- Fig. 5: shows in detail the captured image of a recording system for distance measurement between a laser beam and an FD mark according to an exemplary embodiment of the invention.
- Fig. 6: is a cross-sectional view of a fuselage part with an NSA point and a projected laser beam for distance measurement between the laser beam and the NSA point according to an exemplary embodiment of the invention.
- Fig. 7: shows an arrangement of two best-fit planes of a segment relative to one another according to an exemplary embodiment of the invention.
- Fig. 8: shows an apparatus for aligning segments according to an exemplary embodiment of the invention.
- Fig. 9: is a flow chart for a method for aligning segments according to an exemplary embodiment of the invention.

### Detailed description of embodiments

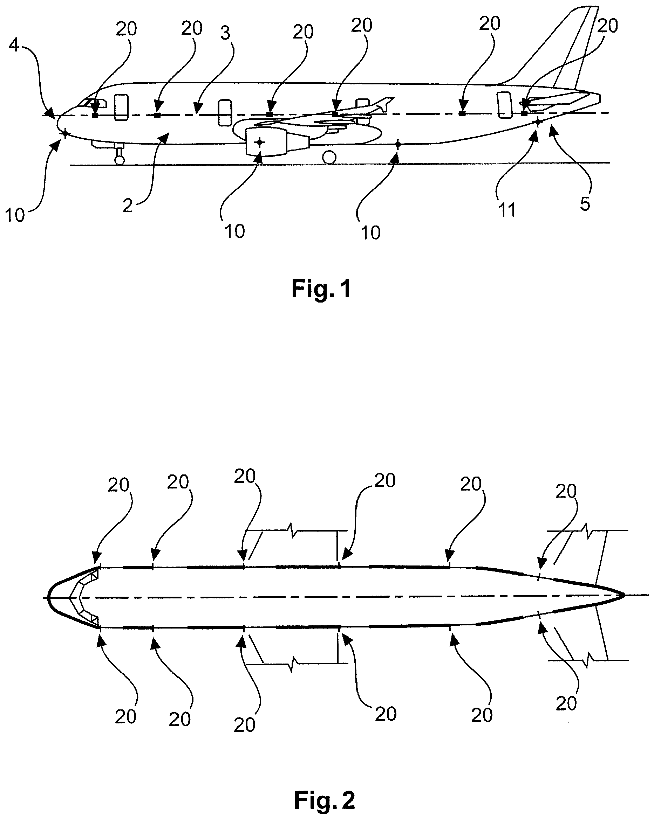

The drawings in the figures are schematic and not true-to-scale. In the following description of Fig. 1 to 9, the same reference numerals are used for the same or corresponding elements.

Although the following description is directed at a method and an apparatus for aligning aircraft fuselage parts with one another, this is not to be construed as restrictive. The method and alignment apparatus can be used for any type, shape and size of segments. The method and/or apparatus provide the possibility of accurately positioning the sections of an aircraft fuselage. In particular, the method and/or apparatus can ensure a precise positioning of the fuselage parts. Furthermore, it is thereby possible to ensure the observance of overall tolerances of the aircraft fuselage in the final assembled state.

Reference points and/or reference marks based on or referred to an aircraft coordinate system can be provided on the fuselage parts of the aircraft. In this respect, the x-axis of the aircraft coordinate system runs along the longitudinal axis of the cylindrical aircraft fuselage parts. The z-axis of the aircraft coordinate system is the vertical axis of the aircraft fuselage parts and the y-axis stands vertically or perpendicularly on the z-axis and x-axis according to a right-hand system and is oriented in the direction of the wingspan. The origin of this aircraft coordinate system lies in the region of the aircraft nose in front of the cockpit. The aircraft coordinate system is also called the AC coordinate system.

Some of the reference points are referred to as NSA points and fix the rotational degree of freedom about the z-axis and the translational degree of freedom in the y-direction. This means that the AC coordinate system is defined, for example, via the use of the NSA points for the definition of ROT-Z and TR-Y and via the use of the FD marks for the definition of ROT-X, ROT-Y and TR-Z. The term ROT-Z is used as an abbreviation for a rotation about the z-axis and the term TR-Y is used as an abbreviation for a translation in the y-direction.

Further reference points are referred to as FD marks and fix the rotational degrees of freedom about the x-axis and the y-axis as well as the translational degree of freedom in the z-direction. Analogously, the abbreviation ROT-X is used for a rotation about the x-axis, ROT-Y is used for a rotation about the y-axis and TR-Z is used for a translation in the z-direction.

Fig. 1 is a side view of a possible position and arrangement of the NSA points 10, 11 and of the FD marks 20 on the fuselage of an aircraft. There are two NSA points 10 per fuselage part which are applied, for example, 45 mm outside the centre along the underside of the fuselage. This means that they lie at y =+/- 45 mm. The associated plane is called plane y-45 RHS (right hand system). Based on the longitudinal axis 3 of the fuselage parts which coincides with the x-axis of the aircraft coordinate system, the foremost NSA point 10 is located under the radome 4 in the region of the aircraft nose, the rearmost NSA point 11 is located under a cover for a jacking point in the spherical region 5. A radome 4 is a closed protective sheathing for directional and radar antennae which, in the case of aircraft, are usually located in the region of the aircraft nose. The spherical region 5 is characterised by a rounded contour on the aircraft tail. The NSA point 10 under the radome 4 is applied by a holder on the front pressure bulkhead. A holder can be a specifically formed component, such as a bent sheet metal part. This bent sheet metal part can be riveted to the primary structure of the aircraft, for example to the stringers and formers.

The FD marks 20 are applied to the aircraft fuselage or to the fuselage outer skin based on or referred to the AC coordinate system when z = zero, parallel to the x-axis or parallel to the aircraft longitudinal axis 3. Fig 2 shows six FD marks on the rear fuselage between the indicated wings and the tail unit and four FD marks 20 on the front fuselage between the nose of the aircraft and the wings. Further FD marks 20 shown in Fig. 2 are applied, for example after the final coating of paint.

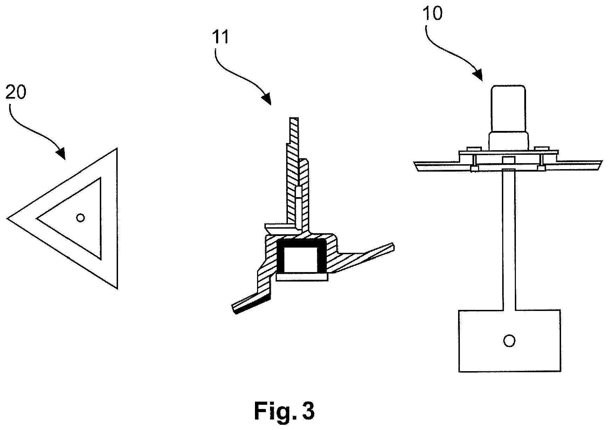

Fig. 3 is a detail view of the NSA points 10 and the FD marks 20 as well as the NSA point 11 which is arranged in the spherical region 5. The NSA points 10, 11 can be applied or adapted to the respective fuselage part by means of an adapter or measuring adapter, i.e. a fastening apparatus. A corresponding adapter is shown in points 10 and 11 to provide a clearer understanding. The adapter can be inserted into corresponding reception points in the fuselage part, or attached thereto, in defined positions. A target, i.e. a target point, can be attached to the adapter. A target is a target point from which a centre point can be constructed by the image capturing software. The FD marks 20 can be applied in defined positions to the fuselage part, for example in the form of adhesive labels.

The NSA points 10 and 11 and/or FD marks 20, as shown in Fig. 1 and 2, serve as reference points for the later alignment of the individual fuselage parts with one another. The FD marks 20 can be applied manually, for example using a pencil marking. In one example, the marks can be applied in the MCA (major component assembly), section assembly or on the construction site. According to the ground test requirement (GTR), an accuracy of the FD marks 20 of +/- 0.5 mm is required in the z-direction. In the x-direction, an accuracy of +/- 10 mm is specified. This means that an FD mark can deviate at most by 10 mm from its desired position in the x-direction and at most by 0.5 mm from its desired position in the z-direction. A deviation of the reference points from their desired positions is produced, for example by a deformation of a fuselage part, during which the reference points move relative to one another. The reference points are in their desired positions, for example, when there is no deformation of the fuselage parts.

A short distance between the FD marks 20 in the x-direction is to be mentioned as an additional restriction to the use of the FD marks 20 in the front fuselage part. A short distance between two features or reference points promotes an extrapolation error. For example, if a straight line is defined by two measurement points which are arranged at a short distance from one another, then a small deviation from the nominal position of these measurement points is expressed by the extrapolation in a large deviation at a greater distance from these two measurement points. Thus, it can be favourable to use FD marks 20 which are spaced apart from one another as far as possible. The mentioned reference points, i.e. the FD marks 20 and the NSA points 10 and 11, can be used for a check which makes it possible to establish whether a deformation of the fuselage has occurred due to mechanical stress. This leads to a deviation of the reference points from their desired positions. For example, the position of the NSA points with reference to the AC coordinate system can be checked by a measurement campaign.

The method according to the invention describes a possibility of aligning or levelling fuselage parts of an aircraft using a laser projection technique and a system for aligning or levelling fuselage parts of an aircraft using a laser projection technique. Here, lines are generated on objects by deflecting laser beams. Thus, projection lines are generated on the fuselage parts, the projection devices and thereby the generated projection lines having a defined position within the construction site coordinate system.

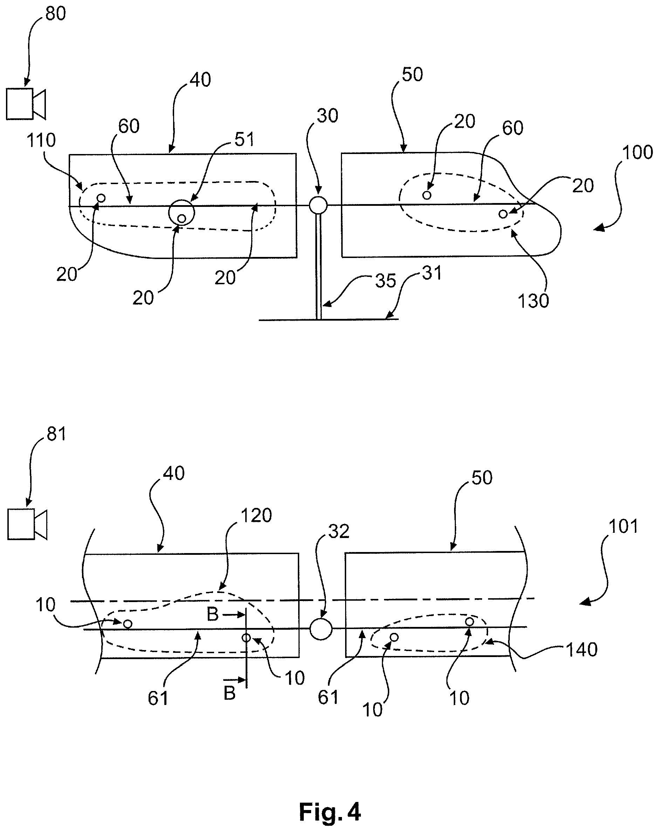

Fig. 4 is a side view 100 and a bottom view 101 of the laser projection in the construction site onto two fuselage parts of an aircraft. The construction site is, for example, an assembly hall in which laser projectors are installed on appropriate apparatuses to project onto the aircraft fuselage the references or projection lines corresponding to the above-described reference points, based on or referred to the aircraft coordinated system (AC coordinate system). This means that a first plane (z = 0) is displayed laterally on a first segment 40 or on a first fuselage part and on a second segment 50 or on a second fuselage part by a first laser beam 60 from a first laser projector 30. Segment 40 is a rear fuselage part and segment 50 is a front fuselage part. The laser beam 60 spans segments, i.e. it is generated from a single source and passes across both segments. This connection can be clearly seen in the side view 100 in Fig. 4.

A second plane, i.e. the plane y = 45, is displayed on the first segment 40 and on the second segment 50 by using a second laser beam 61 from a second laser projector 32 out of the ground 31. "Out of the ground" means that the laser projector is arranged in the ground, for example, so that the laser beam 61 is projected onto the two segments or fuselage parts upwards from below, i.e. in the direction of segment 40 and segment 50, in the x-z plane when y = 0. Thus, the plane y-45 RHS (right hand system) is displayed onto the two segments by a laser beam from out of the ground. The second laser beam 61 also spans the segments. This context or relation can be seen in the bottom view 101 of Fig. 4.

Recording systems 80 are installed on the construction site, in every position in which there is an FD mark 20 and an NSA point 10 and 11. This means that the recording systems 80 are based on or referred to the construction site coordinate system. The recording systems 80 can be, for example, measuring devices, such as cameras and they film both the projected laser beam and the respective NSA point 10 and 11 and the respective FD mark 20. In this respect, the position of the first laser projector 30 and of the second laser projector 32 based on or referred to the construction site coordinate system is known. The first laser projector 30 is connected to the floor by a connection element 35, for example. The correct position of the laser projectors, based on the construction site coordinate system, is checked regularly during a periodic examination. The FD marks 20 of the first segment 40 form a first group of reference points 110. The NSA points of the first segment form a second group of reference points 120. The FD marks of the second segment 50 form a third group of reference points. The NSA points of the second segment form a fourth group of reference points. Further groups of reference points can be provided on each segment.

The fuselage parts 40, 50 are aligned, for example on positioning devices (which means are not shown in Fig. 4). These positioning devices have a plurality of mobile towers which can be moved independently of one another such that the fuselage parts can be moved in all directions and can be rotated about all axes. It is possible to imagine this as a roll of toilet paper supported by four pencils. The height of each individual tower and pencil, respectively can be varied. All the pencils are normally moved in a uniform manner. However, if the fuselage is to be rotated, only two towers on the same side can be moved. This is called asymmetric travel of the towers. Before the fuselage parts are introduced, the towers are lowered in the z-direction by a fixed value and moved to the intended nominal position in the y- and x-directions so that the fuselage parts are roughly aligned. After the fuselage parts have been positioned in the apparatus, the towers are raised in the z-direction into the nominal position. Due to this step, for example the clearance in the spindles can be minimised, as a result of which displacement inaccuracies in the spindles of the mounts are minimised. This can be achieved because the end positions into which the fuselage parts are brought are approached from one direction, the accuracy of the end position being subject to the constructive configuration of the apparatus, i.e. the positioning device. It is possible to prevent a hollow state of metal fittings in that a divergence between the position of the hot fitting balls or hoist fitting balls and ball seats continues during a uniform lifting procedure. Hoist fitting balls or hot fitting balls are fittings, which have a ball socket into which the towers can engage. For this purpose, a hoist fitting ball of this type or a hot fitting ball of this typ is provided at one end of the towers. This can be imagined as a type of ball-and-socket joint which is used during alignment of the segments with one another.

The measuring device or an installed camera detects, for example, a movement of the FD marks 20 with reference to the projected laser beam, as a result of which it is possible to automatically recognise a hollow metal fitting or a fitting not having contact. For example, if the translation of the FD marks is not consistent with the translation to be expected by the travel path x, it is possible to deduce a hollow metal fitting or a fitting not having contact.

The alignment process is carried out after the fuselage parts have been introduced into the positioning device. At the start of the process, the towers are in the nominal position in the z-direction. Thereafter, the installation starts to project the laser beams onto the fuselage. The cameras send the filmed images to software. This software can recognise FD marks 20 and NSA points 10 and 11 and can construct therefrom a centre point. For this purpose, a camera captures an image 51, from which the distance of the centre point of the FD mark to a projected line is calculated. The software of the Flex-Track drilling robot system can be used, for example, as the image capturing software. The distance is determined by a measuring device based on the centre points, detected by the image capturing software, of the NSA points 10 and 11 and/or of the FD marks 20. The evaluation device 95, in particular the image capturing software, can detect real geometries and can idealise and/or calculate therefrom specific geometric variables. For example, the image capturing software can calculate the centre point of an FD mark using an outline.

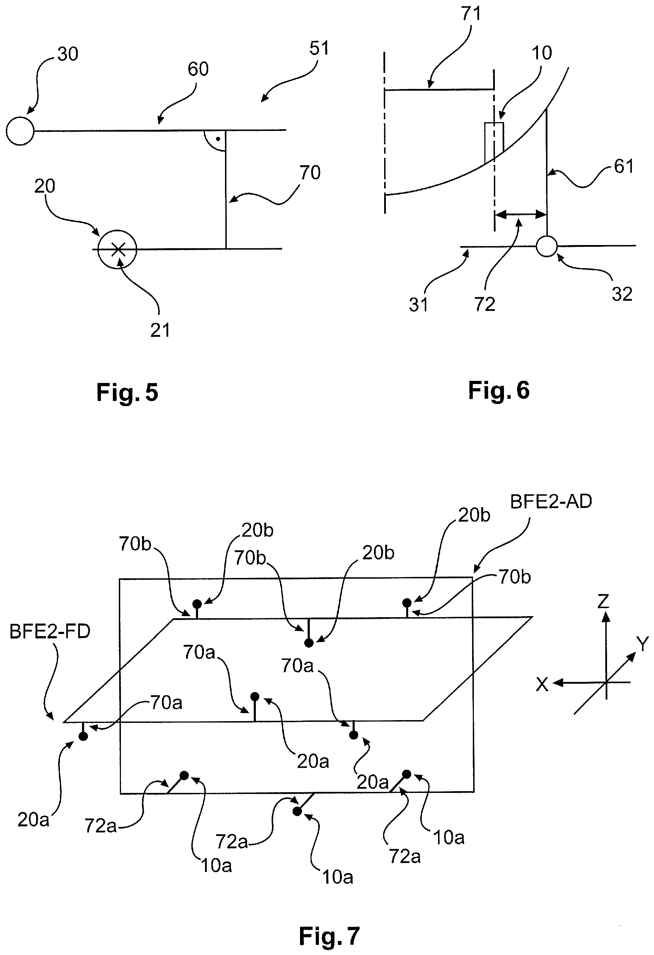

Fig. 5 shows in detail an image 51 which is captured by a recording system 80 and can be used to construct a centre point 21 of a reference point. The centre point 21 can be constructed, for example by the image capturing software of a recording system 80. This image 51 of the recording system 80, for example a camera, can be used to construct the centre point 21 and to determine the distance 70 between the first laser beam 60 and the centre point 21 of an FD mark 20 to calculate the position of the FD mark 20 based on the construction site coordinate system. According to the representation in Fig. 5, the distance to the projected laser beam 60 is measured by letting fall a perpendicular onto the first laser beam 60 from the constructed centre point 21 of the FD mark 20.

Analogously, according to the representation in Fig. 6, a perpendicular is let fall onto the second laser beam 61 from the constructed centre point of the NSA point 10 and/or 11 to measure the distance between the centre point of the NSA point and the second laser beam 61. The coordinates of the FD marks 20 and of the NSA points 10 and 11 are calculated from the provided information, based on or referred to the construction site coordinate system. In an example, the NSA point can be applied to the respective fuselage part using an adapter or measuring adapter, i.e. a fastening apparatus. Fastened to this adapter can be a target, i.e. a target point, from which the image capturing software can construct a centre point. The measuring adapter can be attached to or inserted at specific points of a fuselage part.

Fig. 6 is a cross-sectional view of a fuselage part with an NSA point 10 which is recorded by a second recording system 81 and can be used to construct a centre point of the NSA point. The cross section is viewed from direction B-B in Fig. 4. An image generated by the recording system 81 can be used to construct the centre point of the NSA point and to determine the distance 72 between the second laser beam 61 and the centre point of an NSA point 10 or 11. The position of the NSA point 10 or 11 is calculated by the second recording system 81 with respect to the construction site coordinate system, so that the coordinates and the spatial arrangement of the NSA points 10 and 11 with respect to the construction site coordinate system are also known.

Any number of recording systems or measuring devices can be provided. For example, one recording system can be allocated to each FD mark 20 and to each NSA point 10 and 11. These recording systems are measuring devices which construct the centre points of the reference points (FD marks 20 and NSA points 10 and 11) and determine the distance of these centre points to the projected lines by letting fall a perpendicular onto the projected lines.

Calculated from the measurement information, determined optically by the recording systems, of the reference points are theoretical and/or virtual best-fit planes which thus represent AD and FD references of the respective fuselage part for alignment. AD is the abbreviation for aircraft datum and FD is the abbreviation for fuselage datum.

Table 1 shows a naming convention of the best-fit planes. The table shows that two fuselage parts respectively comprise two best-fit planes. The first fuselage part (AFT section) is defined by six FD marks which represent the reference for determining the first best-fit plane (BFE2-FD) of the first fuselage part. The first fuselage part (AFT section) also has two NSA points which represent the reference for determining the second best-fit plane (BFE2-AD) of the first fuselage part. The second fuselage part (FWD section) is defined by four FD marks which represent a reference for determining the first best-tit plane (BFE1-FD) of the second fuselage part. The second fuselage part (FWD section) also has two NSA points which represent the reference for determining the second best-fit plane (BFE1-AD) of the second fuselage part.

**Table 1:**

| *Abbreviation of the best-fit plane (BFE) using the reference surface (FD or AD) defined by the BFE and allocating to the front or rear fuselage portion (1 or* 2) | *Description of the definition* | *Theoretical orientation of the plane based on the AC coordinate system* |
|---|---|---|
| BFE1-FD | FWD section defined by four FD marks of the front section | x-y plane |
| BFE2-FD | AFT section defined by six FD marks of the rear section | x-y plane |
| BFE1-AD | FWD section defined by two NSA points of the front section | x-z plane |
| BFE2-AD | AFT section defined by two NSA points, orthogonally on BFE2-FD | x-z plane |

The fuselage parts can be levelled using the best-fit planes. For the levelling procedure, the required travel paths of the towers in the y- and z-directions are calculated to obtain the shortest possible distance between the projected laser beams and the theoretical planes BFE1-FD, BFE2-FD, BFE1-AD and BFE2-AD in all measurement positions. Further features of the segments apart from the best-fit planes or optionally the best-fit lines no longer have to be considered for alignment, because these features, such as a base plate, are also aligned by the alignment of the best-fit planes and/or the best-fit lines. A plurality of measuring devices can be provided which all measure the distances between the best-fit planes and the laser beams. An asymmetrical travel or movement of the towers is also possible during levelling of the fuselage parts. This means that the towers can be moved to different extents. In an arrangement of four towers which support one fuselage part, if for example two towers in each case are moved at the same speed, this fuselage part can be rotated about an axis. A lifting apparatus can comprise a plurality of towers which align the fuselage parts with one another. At the end of orientation or set up, the position and/or orientation of the two fuselage parts is unambiguously defined in the x-y plane and also in the x-z plane.

After levelling, the fuselage parts can be aligned with one another by adjusting the best-fit planes to one another. During alignment, the vertical distance between the planes BFE1-FD and BFE2-FD is adjusted or minimised by simultaneously lowering and/or raising the towers. This means that these planes can be congruent after alignment. The fuselage parts can be aligned by an evaluation device and in particular by software used for the evaluation device and thus by the construction site control device.

Fig. 7 shows an arrangement of two best-fit planes of a first segment 40 (the first segment is not shown in Fig. 7 for reasons of clarity) relative to one another according to an exemplary embodiment of the invention. Thus, Fig. 7 is a representation of the theoretical best-fit planes of a first segment 40, for example of the rear section of an aircraft fuselage. This arrangement of corresponding best-fit planes is determined for each segment independently of one another. The best-fit planes are determined, for example by a regression method while considering the coordinates of the NSA points 10a and FD marks 20a, 20b. The first best-fit plane BFE2-FD is generated, for example on the basis of two groups of reference points. The first group of FD marks 20a is arranged laterally on the first segment 40 substantially along a first common line along the aircraft longitudinal axis when z = 0. A fifth group of FD marks 20b is also arranged laterally on the first segment 40 on the opposite side, substantially along a fifth common line along the aircraft longitudinal axis when z = 0. Two laser projectors project a respective laser beam (not shown here) from different directions onto the first segment 40. This means that a first laser projector projects a first projection line along the first common line and a fifth projection device projects a fifth projection line along the fifth common line. To determine the spatial arrangement of the first group of FD marks 20a, the distances of the FD marks of the first group of FD marks 20a to the first projection line are determined. These distances to the first common line are not the distances 70a to the best-fit plane BFE2-FD. To determine the spatial arrangement of the fifth group of FD marks 20ab, the distances of the FD marks of the fifth group of FD marks 20b to the fifth projection line are determined. These distances to the fifth common line are not the distances 70b to the second best-fit plane BFE2-AD. Using the calculated spatial arrangement of the FD marks of the first and fifth groups, the first best-fit plane BFE2-FD is determined by regression for example, the distances 70a and 70b between the first best-fit plane BFE2-FD and the FD marks 20a and 20b being minimised. Furthermore, a group of NSA points 10a is arranged on the underside of the segment substantially along a second common line along the aircraft longitudinal axis. A second laser projector projects a second projection line along the second common line. To determine the spatial arrangement of the group of NSA points 10a, the distances of the NSA points of the second group of NSA points 10a to the second projection line is determined. These distances to the second common line are not the distances 72a to the best-fit plane BFE2-AD.

Using the determined spatial arrangement of the group of NSA points 10a, a second best-fit plane BFE2-AD is determined by regression for example, so that the second best-fit plane BFE2-AD is rotated by 90 degrees about the aircraft longitudinal axis with respect to the first best-fit plane BFE2-FD. During the determination of the second best-fit plane BFE2-AD, the distances 72a between the second best-fit plane BFE2-AD and the NSA points 10b are minimised.

During alignment of the best-fit planes with one another, the best possible conformity of the planes BFE1-AD and BFE2-AD is calculated and an attempt is also made to minimise the horizontal distance of the planes by parallel movement. In other words, this may mean that the best-fit planes can be calculated and aligned with one another substantially simultaneously or in parallel. After alignment, the planes BFE1-AD and BFE2-AD can also be congruent. For alignment of the best-fit planes, the total of the squared distances of a defined number of points to the planes is minimised. Analogously, best-fit lines can also be aligned if best-fit lines are used instead of or in addition to best-fit planes.

The two separation areas at which the segments are to be joined together can then be measured. Finally, a good fit of the transverse joint is calculated while observing the described specifications and restrictions, so that possible base plates of the fuselage parts are aligned flush or in line with one another.

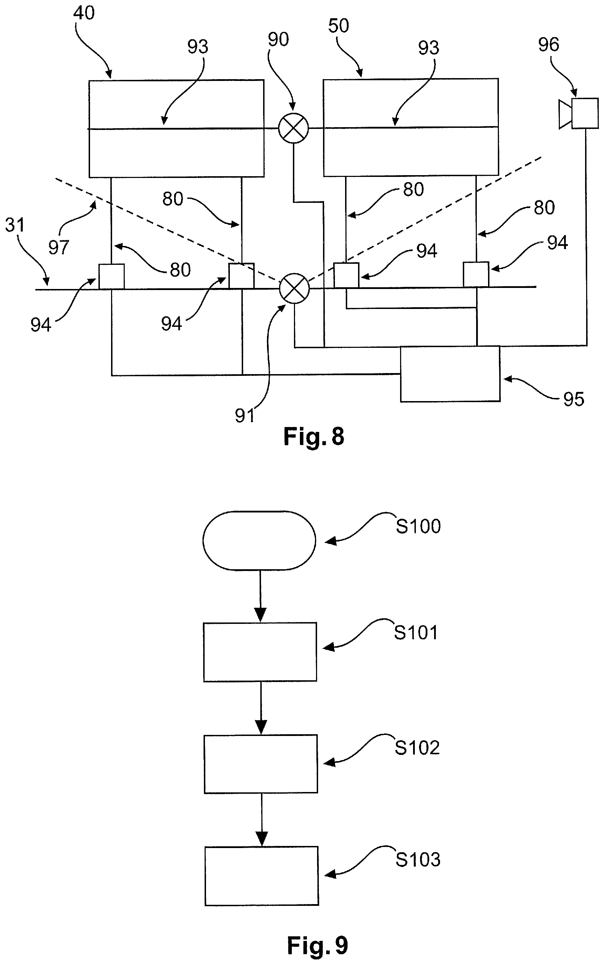

Fig. 8 shows an apparatus for aligning segments 40, 50 with one another. In this respect, a first segment 40 and a second segment 50 are jacked up onto a lifting apparatus 80, 94. The lifting apparatus comprises any number of towers 80 for each segment. The towers 80 are connected to positioning devices 94 which control or drive the towers and thus can move them. The towers can also be considered as part of the positioning device. The positioning devices 94 are in turn connected to an evaluation device 95 and are controlled or driven thereby, for example by wired and/or wireless data transmission. Furthermore, the apparatus has a first projection device 90 and a second projection device 91 for projecting projection lines 93 onto the two segments. The first projection device 90 is, for example, connected to the floor by a connection element (not shown here) or by a stand. The second projection device 91 is arranged in the floor, for example. The second projection device 91 is configured to project projection lines onto the first segment 40 and onto the second segment 50 from out of the floor 31. For this purpose, the second projection means 91 can deflect the projected beams within a specific angular range 97 which includes both segments. A laser beam and or a laser, for example, may be used to project the beams which is moved on a plane between a predeterminable angular region 97 so that a line is produced when the beam strikes the segment surfaces. The angular range 97 may be respectively selected such that the line is projected onto both segments. In the same way, the first projection device 90 can also project a projection line onto the two segments laterally in a plane z = 0. The projection devices 90 and 91 are connected to the evaluation device 95, for example by wired and/or wireless data transmission. The apparatus also has a measuring device 96, which can determine the distances between the projection lines and the reference points applied to the segments. This measuring device 96 is, for example, a recording system with detection software for optically measuring distances. The measuring device 96 can also be connected to the evaluation unit 95 by wired and/or wireless data transmission. In this manner, the evaluation unit 95 can determine the best-fit planes and can control an alignment process of the segments via the positioning device 94 based on the calculated distances.

Fig. 9 is a flow chart for a method for aligning segments. In step S 100, a first projection line is projected onto a first segment and onto a second segment by a first projection device and a second projection line is projected onto the first segment and onto the second segment by a second projection device. In step S101, the distances between each of the reference points of a first group to the first projection line and between each of the reference points of a third group to the first projection line are measured by letting fall a perpendicular onto the first projection line and the distances between each of the reference points of a second group to the second projection line and between each of the reference points of a fourth group to the second projection line are measured by letting fall a perpendicular onto the second projection line. In step S102, a first best-fit plane of the first segment and a second best-fit plane of the first segment are determined and a first best-fit plane of the second segment and a second best-fit plane of the second segment are determined. In a further step S103, the first best-fit plane of the first segment and the first best-fit plane of the second segment are aligned on the first projection line and the second best-fit plane of the first segment and the second best-fit plane of the second segment are aligned on the second projection line. In addition or alternatively to determining and aligning a best-fit plane, it is possible to determine and align a best-fit line.

In spite of high investment costs for the recording system and complex construction site integration, the method makes it possible to achieve an increase in manufacturing accuracy and a reduction in processing time. The alignment accuracy can be increased by determining and increasing the optical recording accuracy. A high level of accuracy during application of the markers can lead to a high manufacturing accuracy and alignment accuracy due to the dependence on positioning accuracy of the FD marks and NSA points on the fuselage sections. The positioning accuracy of the FD marks and NSA points, for example, can be established or determined for this purpose.

The method and/or apparatus make it possible to automate the levelling of the sections or segments and thereby the quality can be improved and processing time can be reduced which reduces or compensates the additional expenditure of the separation location measurement. The use of best-fit planes can substantially eliminate the human factor in the calibration process. Due to measuring in the construction site coordinate system, it is possible to become independent of measurement information from internal and external suppliers, i.e. the measurement data are generated directly on site in the final assembly line.

An incorrect positioning of the hoist fittings or hot fittings on the fuselage may not affect the measurement and alignment processes, because the fuselage parts are levelled using references, which are independent of the hoist fittings or hot fittings. A reliable starting reference is provided for the maximum travel paths or move paths. The nominal position of the apparatus may be unsatisfactory as the starting reference because an unambiguous position of the fuselage parts via the hoist fittings or hot fittings does not necessarily result therefrom. This means that the position of the fuselage parts inside the apparatus, i.e. inside the positioning device, is defined by hoist fittings or hot fittings so that the starting position of the fuselage parts depends on the placement accuracy of the hoist fittings or hot fittings.

For aerodynamic reasons, the overall tolerances inside the fuselage geometry may be to be met, thereby resulting in maximum transport paths of the mobile towers.

The AC coordinate system is defined independently of the floor and can be transferred into the construction site coordinate system by measuring on the construction site. Since reference points are used which are often already present for measurement purposes, the fuselage may do not have to undergo any structural changes; all that is necessary is for the suitability of already present features and reference points to be verified and for the positioning accuracy thereof to be optimised, if necessary.

Only the separation locations and possibly the NSA points may have to be fitted with measuring adapters. The NSA points only have to be fitted with measuring adapters if the image capturing software cannot be referenced on the centre point of the NSA points.

By lowering the apparatus before the fuselage parts are introduced with a subsequent approach towards the end position in the z-direction, it is possible to increase the accuracy and to avoid the hollow state or the contactless state of metal fittings.

To check the dimensional accuracy of production, the method and/or device can further provide the verification of the total aircraft geometry after the joining process.

In addition, it is pointed out that the term "comprising" does not exclude any other elements or steps and "a" or ``one" does not exclude a plurality. It is also pointed out that features or steps which have been described with reference to one of the above embodiments can also be used combined with other features or steps of other embodiments described above. Reference numerals in the claims should not be construed as limiting the scope of the claims.

## Claims

1. Method for aligning segments with one another,
wherein a first segment (40) has a first group (110) of reference points (20) and a second group (120) of reference points (10);
wherein a second segment (50) has a third group (130) of reference points (20) and a fourth group (140) of reference points (10);
wherein the reference points (20, 10) of the first and third groups (110, 130) are substantially located on a first common line running parallel to a longitudinal axis of the first and second segments (40, 50);
wherein the reference points (20, 10) of the second and fourth groups (120, 140) are substantially located on a second common line running parallel to a longitudinal axis of the first and second segments (40, 50), comprising:
projecting a first projection line (60, 93) onto the first segment (40) and onto the second segment (50) by a first projection device (90),
projecting a second projection line (61) onto the first segment (40) and onto the second segment (50) by a second projection device (91),
wherein the first projection line (60, 93) is related to the first common line;
wherein the second projection line (61) is related to the second common line;
measuring the distances (70) between each of the reference points (20, 20a) of the first group to the first projection line and between each of the reference points (20) of the third group to the first projection line (60, 93) by letting fall a perpendicular onto the first projection line (60, 93);
measuring the distances between each of the reference points (10) of the second group to the second projection line (61) and between each of the reference points (10) of the fourth group to the second projection line (61) by letting fall a perpendicular onto the second projection line (61);
determining a first best-fit line and/or a first best-fit plane of the first segment (40);
determining a second best-fit line and/or a second best-fit plane of the first segment (40);
determining a first best-fit line and/or a first best-fit plane (BFE2-FD) of the second segment (50);
determining a second best-fit line and/or a second best-fit plane (BFE2-AD) of the second segment (50);
aligning the first best-fit line and/or the first best-fit plane of the first segment (40) on the first projection line (60, 93);
aligning the first best-fit line and/or the first best-fit plane (BFE2-FD) of the second segment (50) on the first projection line (60, 93);
aligning the second best-fit line and/or the second best-fit plane of the first segment (40) on the second projection line (61);
aligning the second best-fit line and/or the second best-fit plane (BFE2-AD) of the second segment (50) on the second projection line (61).

2. Method according to any of the preceding claims, further comprising:
projecting a further projection line onto the first segment and onto the second segment by a further projection device.

3. Method according to either of the preceding claims, wherein the distance measurement and/or the alignment procedure are carried out with reference to a construction site coordinate system.

4. Method according to any of the preceding claims, further comprising:
aligning the first best-fit line of the first segment (40) and the first best-fit line of the second segment (50) such that the first best-fit line of the first segment (40) and the first best-fit line of the second segment (50) are congruent and/or aligning the second best-fit line of the first segment (40) and the second best-fit line of the second segment (50) such that the second best-fit line of the first segment (40) and the second best-fit line of the second segment (50) are congruent.

5. Method according to any of the preceding claims, further comprising:
aligning the first best-fit plane of the first segment (40) and the first best-fit plane (BFE2-FD) of the second segment (50) such that the first best-fit plane of the first segment (40) and the first best-fit plane (BFE2-FD) of the second segment (50) are congruent and/or aligning the second best-fit plane of the first segment (40) and the second best-fit plane (BFE2-AD) of the second segment (50) such that the second best-fit plane of the first segment (40) and the second best-fit plane (BFE2-AD) of the second segment (50) are congruent.

6. Method according to any of the preceding claims, further comprising:
aligning the first best-fit line of the first segment (40) and the first best-fit line of the second segment (50) such that the first best-fit line of the first segment (40) and the first best-fit line of the second segment (50) have a minimum distance to the first projection line (60, 93) and/or aligning the second best-fit line of the first segment (40) and the second best-fit line of the second segment (50) such that the second best-fit line of the first segment (40) and the second best-fit line of the second segment (50) have a minimum distance to the second projection line (61).

7. Method according to any of the preceding claims, further comprising:
aligning the first best-fit plane of the first segment (40) and the first best-fit plane (BFE2-FD) of the second segment (50) such that the first best-fit plane of the first segment (40) and the first best-fit plane (BFE2-FD) of the second segment (50) have a minimum distance to the first projection line (60, 93) and/or aligning the second best-fit plane of the first segment (40) and the second best-fit plane (BFE2-AD) of the second segment (50) such that the second best-fit plane of the first segment (40) and the second best-fit plane (BFE2-AD) of the second segment (50) have a minimum distance to the second projection line (61).

8. Method according to any of the preceding claims, wherein the two segments are fuselage parts with a base plate.

9. Computer-readable storage medium with a program code which, when executed on a processor connected to and controlling the apparatus of claim 10, implements the method for aligning segments according to any of the preceding claims.

10. Apparatus for aligning segments with one another, comprising:
a first projection device(30, 90);
a second projection device (31, 91);
a measuring device (80, 81, 96);
an evaluation device (95);
a positioning device (94);
wherein a first segment (40) has a first group (110) and a second group (120) of reference points (20, 10);
wherein a second segment (50) has a third group (130) and a fourth group (140) of reference points (20, 10);
wherein the reference points (20, 10) of the first group (110) and of the third group (130) substantially lie on a first common line running parallel to a longitudinal axis of the first segment (40) and second segment (50);
wherein the reference points (20, 10) of the second group (120) and of the fourth group (140) substantially lie on a second common line running parallel to a longitudinal axis of the first segment (40) and second segment (50);
wherein the first projection device (90) is configured to project a first projection line (60, 93) onto the first segment (40) and onto the second segment (50);
wherein the second projection device (91) is configured to project a second projection line (61) onto the first segment (40) and onto the second segment (50);
wherein the first projection line (60, 93) is related to the first common line;
wherein the second projection line (61) is related to the second common line;
wherein the measuring device (96) is configured to measure the distances (70) between each of the reference points (20, 20a) of the first group to the first projection line and between each of the reference points (20) of the third group to the first projection line (60, 93) by letting fall a perpendicular onto the first projection line (60, 93);
wherein the measuring device (96) is further configured to measure the distances between each of the reference points (10) of the second group to the second projection line (61) and between each of the reference points (10) of the fourth group to the second projection line (61) by letting fall a perpendicular onto the second projection line (61);
wherein the evaluation device (95) is configured to determine a first best-fit line and/or a first best-fit plane of the first segment (40);
wherein the evaluation device (95) is further configured to determine a second best-fit line and/or a second best-fit plane of the first segment (40);
wherein the evaluation device (95) is further configured to determine a first best-fit line and/or a first best-fit plane (BFE2-FD) of the second segment (50);
wherein the evaluation device (95) is further configured to determine a second best-fit line and/or a second best-fit plane (BFE2-AD) of the second segment (50);
wherein the positioning device (94) is configured to align the first best-fit line and/or the first best-fit plane of the first segment (40) on the first projection line (60, 93);
wherein the positioning device (94) is further configured to align the first best-fit line and/or the first best-fit plane (BFE2-FD) of the second segment (50) on the first projection line (60, 93);
wherein the positioning device (94) is further configured to align the second best-fit line and/or the second best-fit plane of the first segment (40) on the second projection line (61);
wherein the positioning device (94) is further configured to align the second best-fit line and/or the second best-fit plane (BFE2-AD) of the second segment (50) on the second projection line (61).

## Patentansprüche

1. Verfahren zum Ausrichten von Segmenten zueinander,
wobei ein erstes Segment (40) eine erste Gruppe (110) von Referenzpunkten (20) und eine zweite Gruppe (120) von Referenzpunkten (10) aufweist;
wobei ein zweites Segment (50) eine dritte Gruppe (130) von Referenzpunkten (20) und eine vierte Gruppe (140) von Referenzpunkten (10) aufweist;
wobei die Referenzpunkte (20, 10) der ersten Gruppe und der dritten Gruppe (110, 130) im Wesentlichen auf einer ersten gemeinsamen Linie liegen, die parallel zu einer Längsachse des ersten Segments und des zweiten Segments (40, 50) verläuft;
wobei die Referenzpunkte (20, 10) der zweiten Gruppe und der vierten Gruppe (120, 140) im Wesentlichen auf einer zweiten gemeinsamen Linie liegen, die parallel zu einer Längsachse des ersten und zweiten Segments (40, 50) verläuft, aufweisend:
Projizieren einer ersten Projektionslinie (60, 93) auf das erste Segment (40) und das zweite Segment (50) mit einer ersten Projektionseinrichtung (90),
Projizieren einer zweiten Projektionslinie (61) auf das erste Segment (40) und das zweite Segment (50) mit einer zweiten Projektionseinrichtung (91),
wobei die erste Projektionslinie (60, 93) mit der ersten gemeinsamen Linie in Verbindung steht;
wobei die zweite Projektionslinie (61) mit der zweiten gemeinsamen Linie in Verbindung steht;
Messen der Abstände (70) zwischen jedem der Referenzpunkte (20, 20a) der ersten Gruppe zu der ersten Projektionslinie und zwischen jedem der Referenzpunkte (20) der dritten Gruppe zu der ersten Projektionslinie (60, 93) durch Fällen eines Lotes auf die erste Projektionslinie (60, 93);
Messen der Abstände zwischen jedem der Referenzpunkte (10) der zweiten Gruppe zu der zweiten Projektionslinie (61) und zwischen jedem der Referenzpunkte (10) der vierten Gruppe zu der zweiten Projektionslinie (61) durch Fällen eines Lotes auf die zweite Projektionslinie (61);
Bestimmen einer ersten Best-Fit-Linie und/oder einer ersten Best-Fit-Ebene des ersten Segments (40);
Bestimmen einer zweiten Best-Fit-Linie und/oder einer zweiten Best-Fit-Ebene des ersten Segments (40);
Bestimmen einer ersten Best-Fit-Linie und/oder einer ersten Best-Fit-Ebene (BFE2-FD) des zweiten Segments (50);
Bestimmen einer zweiten Best-Fit-Linie und/oder einer zweiten Best-Fit-Ebene (BFE2-AD) des zweiten Segments (50);
Ausrichten der ersten Best-Fit-Linie und/oder der ersten Best-Fit-Ebene des ersten Segments (40) an der ersten Projektionslinie (60, 93);
Ausrichten der ersten Best-Fit-Linie und/oder der ersten Best-Fit-Ebene (BFE2-FD) des zweiten Segments (50) an der ersten Projektionslinie (60, 93);
Ausrichten der zweiten Best-Fit-Linie und/oder der zweiten Best-Fit-Ebene des ersten Segments (40) an der zweiten Projektionslinie (61);
Ausrichten der zweiten Best-Fit-Linie und/oder der zweiten Best-Fit-Ebene (BFE2-AD) des zweiten Segments (50) an der zweiten Projektionslinie (61).

2. Verfahren nach einem der vorhergehenden Ansprüche, ferner aufweisend:
Projizieren einer weiteren Projektionslinie auf das erste Segment und das zweite Segment mit einer weiteren Projektionseinrichtung.

3. Verfahren nach einem der vorhergehenden Ansprüche,
wobei das Messen der Abstände und/oder das Ausrichten in Bezug auf ein Bauplatzkoordinatensystem erfolgt.

4. Verfahren nach einem der vorhergehenden Ansprüche, ferner aufweisend:
Ausrichten der ersten Best-Fit-Linie des ersten Segments (40) und der ersten Best-Fit-Linie des zweiten Segments (50) derart, dass die erste Best-Fit-Linie des ersten Segments (40) und die erste Best-Fit-Linie des zweiten Segments (50) kongruent sind und/oder Ausrichten der zweiten Best-Fit-Linie des ersten Segments (40) und der zweiten Best-Fit-Linie des zweiten Segments (50) derart, dass die zweite Best-Fit-Linie des ersten Segments (40) und die zweite Best-Fit-Linie des zweiten Segments (50) kongruent sind.

5. Verfahren nach einem der vorhergehenden Ansprüche, ferner aufweisend:
Ausrichten der ersten Best-Fit-Ebene des ersten Segments (40) und der ersten Best-Fit-Ebene (BFE2-FD) des zweiten Segments (50) derart, dass die erste Best-Fit-Ebene des ersten Segments (40) und die erste Best-Fit-Ebene (BFE2-FD) des zweiten Segments (50) kongruent sind und/oder Ausrichten der zweiten Best-Fit-Ebene des ersten Segments (40) und der zweiten Best-Fit-Ebene (BFE2-AD) des zweiten Segments (50) derart, dass die zweite Best-Fit-Ebene des ersten Segments (40) und die zweite Best-Fit-Ebene (BFE2-AD) des zweiten Segments (50) kongruent sind.

6. Verfahren nach einem der vorhergehenden Ansprüche, ferner aufweisend:
Ausrichten der ersten Best-Fit-Linie des ersten Segments (40) und der ersten Best-Fit-Linie des zweiten Segments (50) derart, dass die erste Best-Fit-Linie des ersten Segments (40) und die erste Best-Fit-Linie des zweiten Segments (50) einen minimalen Abstand zur ersten Projektionslinie (60, 93) aufweisen und/oder Ausrichten der zweiten Best-Fit-Linie des ersten Segments (40) und der zweiten Best-Fit-Linie des zweiten Segments (50) derart, dass die zweite Best-Fit-Linie des ersten Segments (40) und die zweite Best-Fit-Linie des zweiten Segments (50) einen minimalen Abstand zur zweiten Projektionslinie (61) aufweisen.

7. Verfahren nach einem der vorhergehenden Ansprüche, ferner aufweisend:
Ausrichten der ersten Best-Fit-Ebene des ersten Segments (40) und der ersten Best-Fit-Ebene (BFE2-FD) des zweiten Segments (50) derart, dass die erste Best-Fit-Ebene des ersten Segments (40) und die erste Best-Fit-Ebene (BFE2-FD) des zweiten Segments (50) einen minimalen Abstand zur ersten Projektionslinie (60, 93) aufweisen und/oder Ausrichten der zweiten Best-Fit-Ebene des ersten Segments (40) und der zweiten Best-Fit-Ebene (BFE2-AD) des zweiten Segments (50) derart, dass die zweite Best-Fit-Ebene des ersten Segments (40) und die zweite Best-Fit-Ebene (BFE2-AD) des zweiten Segments (50) einen minimalen Abstand zur zweiten Projektionslinie (61) aufweisen.

8. Verfahren nach einem der vorhergehenden Ansprüche,
wobei die beiden Segmente Rumpfteile mit einer Bodenplatte sind.

9. Computerlesbares Speichermedium mit einem Programmcode, der, wenn er auf einem Prozessor ausgeführt wird, der mit der Vorrichtung nach Anspruch 10 verbunden ist und diese steuert, das Verfahren zum Ausrichten von Segmenten nach einem der vorangehenden Ansprüche ausführt.

10. Vorrichtung zum Ausrichten von Segmenten zueinander, aufweisend:
eine erste Projektionseinrichtung (30, 90);
eine zweite Projektionseinrichtung (31, 91);
eine Messeinrichtung (80, 81, 96);
eine Auswerteeinrichtung (95);
eine Positioniereinrichtung (94);
wobei ein erstes Segment (40) eine erste Gruppe (110) und eine zweite Gruppe (120) von Referenzpunkten (20, 10) aufweist;
wobei ein zweites Segment (50) eine dritte Gruppe (130) und eine vierte Gruppe (140) von Referenzpunkten (20, 10) aufweist;
wobei die Referenzpunkte (20, 10) der ersten Gruppe (110) und der dritten Gruppe (130) im Wesentlichen auf einer ersten gemeinsamen Linie liegen, die parallel zu einer Längsachse des ersten (40) und zweiten Segments (50) verläuft;
wobei die Referenzpunkte (20, 10) der zweiten Gruppe (120) und der vierten Gruppe (140) im Wesentlichen auf einer zweiten gemeinsamen Linie liegen, die parallel zu einer Längsachse des ersten (40) und zweiten Segments (50) verläuft;
wobei die erste Projektionseinrichtung (90) dazu ausgeführt ist, eine erste Projektionslinie (60, 93) auf das erste Segment (40) und das zweite Segment (50) zu projizieren,
wobei die zweite Projektionseinrichtung (91) dazu ausgeführt ist, eine zweite Projektionslinie (61) auf das erste Segment (40) und das zweite Segment (50) zu projizieren,
wobei die erste Projektionslinie (60, 93) mit der ersten gemeinsamen Linie in Verbindung steht;
wobei die zweite Projektionslinie (61) mit der zweiten gemeinsamen Linie in Verbindung steht;
wobei die Messeinrichtung (96) ausgeführt ist, die Abstände (70) zwischen jedem der Referenzpunkte (20, 20a) der ersten Gruppe zu der ersten Projektionslinie und jedem der Referenzpunkte (20) der dritten Gruppe zu der ersten Projektionslinie (60, 93) durch Fällen eines Lotes auf die erste Projektionslinie (60, 93) zu messen;
wobei die Messeinrichtung (96) weiter ausgeführt ist, die Abstände zwischen jedem der Referenzpunkte (10) der zweiten Gruppe zu der zweiten Projektionslinie (61) und jedem der Referenzpunkte (10) der vierten Gruppe zu der zweiten Projektionslinie (61) durch Fällen eines Lotes auf die zweite Projektionslinie (61) zu messen;
wobei die Auswerteeinrichtung (95) ausgeführt ist, eine erste Best-Fit-Linie und/oder eine erste Best-Fit-Ebene des ersten Segments (40) zu bestimmen;
wobei die Auswerteeinrichtung (95) weiter ausgeführt ist, eine zweite Best-Fit-Linie und/oder eine zweite Best-Fit-Ebene des ersten Segments (40) zu bestimmen;
wobei die Auswerteeinrichtung (95) weiter ausgeführt ist, eine erste Best-Fit-Linie und/oder eine erste Best-Fit-Ebene (BFE2-FD) des zweiten Segments (50) zu bestimmen;
wobei die Auswerteeinrichtung (95) weiter ausgeführt ist, eine zweite Best-Fit-Linie und/oder eine zweite Best-Fit-Ebene (BFE2-AD) des zweiten Segments (50) zu bestimmen;
wobei die Positioniereinrichtung (94) ausgeführt ist, die erste Best-Fit-Linie und/oder die erste Best-Fit-Ebene des ersten Segments (40) an der ersten Projektionslinie (60, 93) auszurichten;
wobei die Positioniereinrichtung (94) weiter ausgeführt ist, die erste Best-Fit-Linie und/oder die erste Best-Fit-Ebene (BFE2-FD) des zweiten Segments (50) an der ersten Projektionslinie (60, 93) auszurichten;
wobei die Positioniereinrichtung (94) weiter ausgeführt ist, die zweite Best-Fit-Linie und/oder die zweite Best-Fit-Ebene des ersten Segments (40) an der zweiten Projektionslinie (61) auszurichten;
wobei die Positioniereinrichtung (94) weiter ausgeführt ist, die zweite Best-Fit-Linie und/oder die zweite Best-Fit-Ebene (BFE2-AD) des zweiten Segments (50) an der zweiten Projektionslinie (61) auszurichten.

## Revendications

1. Procédé pour aligner des segments l'un sur l'autre,
dans lequel un premier segment (40) comporte un premier groupe (110) de points de référence (20) et un deuxième groupe (120) de points de référence (10) ;
dans lequel un second segment (50) comporte un troisième groupe (130) de points de référence (20) et un quatrième groupe (140) de points de référence (10) ;
dans lequel les points de référence (20, 10) des premier et troisième groupes (110, 130) sont sensiblement positionnés sur une première ligne commune s'étendant parallèlement à un axe longitudinal des premier et second segments (40, 50) ;
dans lequel les points de référence (20, 10) des deuxième et quatrième groupes (120, 140) sont sensiblement positionnés sur une seconde ligne commune s'étendant parallèlement à un axe longitudinal des premier et second segments (40, 50), comprenant les étapes consistant à :
projeter une première droite de projection (60, 93) sur le premier segment (40) et sur le second segment (50), au moyen d'un premier dispositif de projection (90),
projeter une seconde droite de projection (61) sur le premier segment (40) et sur le second segment (50), au moyen d'un second dispositif de projection (91),
dans lequel la première droite de projection (60, 93) se rapporte à la première ligne commune ;
dans lequel la seconde droite de projection (61) se rapporte à la seconde ligne commune ;
mesurer les distances (70) entre chacun des points de référence (20, 20a) du premier groupe et la première droite de projection et entre chacun des points de référence (20) du troisième groupe et la première droite de projection (60, 93), en faisant tomber une perpendiculaire sur la première droite de projection (60, 93) ;
mesurer les distances entre chacun des points de référence (10) du deuxième groupe et la seconde droite de projection (61) et entre chacun des points de référence (10) du quatrième groupe et la seconde droite de projection (61), en faisant tomber une perpendiculaire sur la seconde droite de projection (61) ;
déterminer une première droite de meilleur ajustement et/ou un premier plan de meilleur ajustement du premier segment (40) ;
déterminer une seconde droite de meilleur ajustement et/ou un second plan de meilleur ajustement du premier segment (40) ;
déterminer une première droite de meilleur ajustement et/ou un premier plan de meilleur ajustement (BFE2-FD) du second segment (50) ;
déterminer une seconde droite de meilleur ajustement et/ou un second plan de meilleur ajustement (BFE2-AD) du second segment (50) ;
aligner la première droite de meilleur ajustement et/ou le premier plan de meilleur ajustement du premier segment (40) sur la première droite de projection (60, 93) ;
aligner la première droite de meilleur ajustement et/ou le premier plan de meilleur ajustement (BFE2-FD) du second segment (50) sur la première droite de projection (60, 93) ;
aligner la seconde droite de meilleur ajustement et/ou le second plan de meilleur ajustement du premier segment (40) sur la seconde droite de projection (61) ;
aligner la seconde droite de meilleur ajustement et/ou le second plan de meilleur ajustement (BFE2-AD) du second segment (50) sur la seconde droite de projection (61).

2. Procédé selon l'une quelconque des revendications précédentes, comprenant en outre l'étape consistant à :
projeter une droite de projection supplémentaire sur le premier segment et sur le second segment, au moyen d'un dispositif de projection supplémentaire.

3. Procédé selon l'une ou l'autre des revendications précédentes, dans lequel la mesure de distance et/ou la procédure d'alignement sont exécutées en référence à système de coordonnées de site de construction.

4. Procédé selon l'une quelconque des revendications précédentes, comprenant en outre les étapes consistant à :
aligner la première droite de meilleur ajustement du premier segment (40) et la première droite de meilleur ajustement du second segment (50), de manière que la première droite de meilleur ajustement du premier segment (40) et la première droite de meilleur ajustement du second segment (50) soient congruentes ; et/ou aligner la seconde droite de meilleur ajustement du premier segment (40) et la seconde droite de meilleur ajustement du second segment (50), de manière que la seconde droite de meilleur ajustement du premier segment (40) et la seconde droite de meilleur ajustement du second segment (50) soient congruentes.

5. Procédé selon l'une quelconque des revendications précédentes, comprenant en outre les étapes consistant à :
aligner le premier plan de meilleur ajustement du premier segment (40) et le premier plan de meilleur ajustement (BFE2-FD) du second segment (50), de manière que le premier plan de meilleur ajustement du premier segment (40) et le premier plan de meilleur ajustement (BFE2-FD) du second segment (50) soient congruents et/ou aligner le second plan de meilleur ajustement du premier segment (40) et le second plan de meilleur ajustement (BFE2-AD) du second segment (50), de manière que le second plan de meilleur ajustement du premier segment (40) et le second plan de meilleur ajustement (BFE2-AD) du second segment (50) soient congruents.

6. Procédé selon l'une quelconque des revendications précédentes, comprenant en outre les étapes consistant à :
aligner la première droite de meilleur ajustement du premier segment (40) et la première droite de meilleur ajustement du second segment (50), de manière que la première droite de meilleur ajustement du premier segment (40) et la première droite de meilleur ajustement du second segment (50) soient à une distance minimale de la première droite de projection (60, 93) et/ou aligner la seconde droite de meilleur ajustement du premier segment (40) et la seconde droite de meilleur ajustement du second segment (50), de manière que la seconde droite de meilleur ajustement du premier segment (40) et la seconde droite de meilleur ajustement du second segment (50) soient à une distance minimale de la seconde droite de projection (61).

7. Procédé selon l'une quelconque des revendications précédentes, comprenant en outre les étapes consistant à :
aligner le premier plan de meilleur ajustement du premier segment (40) et le premier plan de meilleur ajustement (BFE2-FD) du second segment (50), de manière que le premier plan de meilleur ajustement du premier segment (40) et le premier plan de meilleur ajustement (BFE2-FD) du second segment (50) soient à une distance minimale de la première droite de projection (60, 93) et/ou aligner le second plan de meilleur ajustement du premier segment (40) et le second plan de meilleur ajustement (BFE2-AD) du second segment (50), de manière que le second plan de meilleur ajustement du premier segment (40) et le second plan de meilleur ajustement (BFE2-AD) du second segment (50) soient à une distance minimale de la seconde droite de projection (61).

8. Procédé selon l'une quelconque des revendications précédentes, dans lequel les deux segments sont des parties de fuselage dotées d'une plaque de base.

9. Support d'enregistrement lisible par ordinateur, comportant un code de programme qui, lorsqu'il est exécuté sur un processeur connecté à l'appareil selon la revendication 10 et le commandant, met en oeuvre le procédé pour aligner des segments selon l'une quelconque des revendications précédentes.

10. Appareil destiné à aligner des segments l'un sur l'autre, comprenant :
un premier dispositif de projection (30, 90) ;
un second dispositif de projection (31, 91) ;
un dispositif de mesure (80, 81, 96) ;
un dispositif d'évaluation (95) ;
un dispositif de positionnement (94) ;
dans lequel un premier segment (40) comporte un premier groupe (110) et un deuxième groupe (120) de points de référence (20, 10) ;
dans lequel un second segment (50) comporte un troisième groupe (130) et un quatrième groupe (140) de points de référence (20, 10) ;
dans lequel les points de référence (20, 10) du premier groupe (110) et du troisième groupe (130) se situent sensiblement sur une première ligne commune s'étendant parallèlement à un axe longitudinal du premier segment (40) et du second segment (50) ;
dans lequel les points de référence (20, 10) du deuxième groupe (120) et du quatrième groupe (140) se situent sensiblement sur une seconde ligne commune s'étendant parallèlement à un axe longitudinal du premier segment (40) et du second segment (50) ;
dans lequel le premier dispositif de projection (90) est conçu pour projeter une première droite de projection (60, 93) sur le premier segment (40) et sur le second segment (50) ;
dans lequel le second dispositif de projection (91) est conçu pour projeter une seconde droite de projection (61) sur le premier segment (40) et sur le second segment (50) ;
dans lequel la première droite de projection (60, 93) se rapporte à la première ligne commune ;
dans lequel la seconde droite de projection (61) se rapporte à la seconde ligne commune ;
dans lequel le dispositif de mesure (96) est conçu pour mesurer les distances (70) entre chacun des points de référence (20, 20a) du premier groupe et la première droite de projection et entre chacun des points de référence (20) du troisième groupe et la première droite de projection (60, 93), en faisant tomber une perpendiculaire sur la première droite de projection (60, 93) ;
dans lequel le dispositif de mesure (96) est conçu en outre pour mesurer les distances entre chacun des points de référence (10) du deuxième groupe et la seconde droite de projection (61) et entre chacun des points de référence (10) du quatrième groupe et la seconde droite de projection (61), en faisant tomber une perpendiculaire sur la seconde droite de projection (61) ;
dans lequel le dispositif d'évaluation (95) est conçu pour déterminer une première droite de meilleur ajustement et/ou un premier plan de meilleur ajustement du premier segment (40) ;
dans lequel le dispositif d'évaluation (95) est conçu en outre pour déterminer une seconde droite de meilleur ajustement et/ou un second plan de meilleur ajustement du premier segment (40) ;
dans lequel le dispositif d'évaluation (95) est conçu en outre pour déterminer une première droite de meilleur ajustement et/ou un premier plan de meilleur ajustement (BFE2-FD) du second segment (50) ;
dans lequel le dispositif d'évaluation (95) est conçu en outre pour déterminer une seconde droite de meilleur ajustement et/ou un second plan de meilleur ajustement (BFE2-AD) du second segment (50) ;
dans lequel le dispositif de positionnement (94) est conçu pour aligner la première droite de meilleur ajustement et/ou le premier plan de meilleur ajustement du premier segment (40) sur la première droite de projection (60, 93) ;
dans lequel le dispositif de positionnement (94) est conçu en outre pour aligner la première droite de meilleur ajustement et/ou le premier plan de meilleur ajustement (BFE2-FD) du second segment (50) sur la première droite de projection (60, 93) ;
dans lequel le dispositif de positionnement (94) est conçu en outre pour aligner la seconde droite de meilleur ajustement et/ou le second plan de meilleur ajustement du premier segment (40) sur la seconde droite de projection (61) ;
dans lequel le dispositif de positionnement (94) est conçu en outre pour aligner la seconde droite de meilleur ajustement et/ou le second plan de meilleur ajustement (BFE2-AD) du second segment (50) sur la seconde droite de projection (61).
